(19) Europäisches Patentamt
European Patent Office
Office européen des brevets

(11) **EP 3 147 936 A1**

(12) **EUROPEAN PATENT APPLICATION**
published in accordance with Art. 153(4) EPC

(43) Date of publication:
**29.03.2017 Bulletin 2017/13**

(51) Int Cl.:
*H01L 21/301* (2006.01)  *C09J 7/02* (2006.01)

(21) Application number: **14894932.4**

(86) International application number:
**PCT/JP2014/066146**

(22) Date of filing: **18.06.2014**

(87) International publication number:
**WO 2015/193991 (23.12.2015 Gazette 2015/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Lintec Corporation**
**Tokyo 173-0001 (JP)**

(72) Inventors:
• **TAYA, Naoki**
**Tokyo 173-0001 (JP)**
• **NITO, Yuki**
**Tokyo 173-0001 (JP)**
• **MIYATAKE, Yusuke**
**Tokyo 173-0001 (JP)**

(74) Representative: **Raynor, Stuart Andrew**
**J A Kemp**
**14 South Square**
**Gray's Inn**
**London WC1R 5JJ (GB)**

(54) **DICING-SHEET BASE FILM AND DICING SHEET**

(57)    A base film (2) for dicing sheets that is used in a dicing sheet (1) comprising the base film (2) and a pressure sensitive adhesive layer (3) laminated on one surface of the base film (2). The base film (2) comprises at least a first resin layer (A) that is in contact with the pressure sensitive adhesive layer (3) of the dicing sheet (1) and a second resin layer (B) that comes into contact with the first resin layer (A) when the base film (2) for dicing sheets is wound up. The second resin layer (B) has a crystallinity of 28% to 45% The ratio of a tensile elastic modulus of the first resin layer (A) to a tensile elastic modulus of the second resin layer (B) is 1.2 to 3.0. The ratio of a thickness of the first resin layer (A) to a thickness of the base film (2) for dicing sheets is 20% to 60%. According to the base film (2) for dicing sheets, the expanding properties are excellent, the occurrence of blocking can be suppressed, and the dicing debris generated during the dicing of a cut object can be reduced.

Fig. 1

**Description**

[Technical Field]

The present invention relates to a dicing sheet to which a cut object such as a semiconductor wafer is attached when the cut object is cut and separated into small element pieces, and also relates to a base film used in the dicing sheet.

[Background Art]

Semiconductor wafers such as silicon and gallium arsenide wafers and various types of packages (which may be collectively referred to as a "cut object," hereinafter) are manufactured in a large diameter state and these are cut and separated (diced) into small element pieces (referred to as "chips, " hereinafter), which are individually released (picked up) and thereafter transferred to a mounting step as the subsequent step. During this operation, a cut object such as a semiconductor wafer undergoes respective steps of dicing, washing, drying, expanding, picking-up and mounting in a state in which the cut object is attached to a dicing sheet that comprises a base film and a pressure sensitive adhesive layer.

In the above expanding, to make it easy to pick up chips, the dicing sheet is expanded to separate the chips from one another and, after the picking up, recovered to the original state. Therefore, the dicing sheet, in particular the base film of the dicing sheet, is required to have stretching properties (expanding properties) that allow expansion and recovery. To this end, polyvinyl chloride films that contain a plasticizer are sometimes used as the base film (Patent Literature 1, 2).

However, when materials having the stretching properties as the above are used as the base film, a problem of blocking may readily occur. That is, when the base film is wound up and then wound off, feeding thereof cannot be performed and/or troubles may occur in the feeding. In addition, when the base film is used as a part of a dicing sheet, the base film may come into close contact with a dicing table to cause transport errors.

According to the commonly-used full-cut dicing as a specific method for the dicing step, a rotating round blade is used for cutting a cut object. In the full-cut dicing, to ensure that the cut object to which the dicing sheet is attached can be completely cut over the entire surface, the pressure sensitive adhesive layer may also be cut beyond the thickness of the cut object and a part of the base film may further be cut.

During this operation, dicing debris comprising materials that constitute the pressure sensitive adhesive layer and base film may arise from the dicing sheet, and the obtained chips may be contaminated with the dicing debris. One form of such dicing debris is filament-like dicing debris that attaches onto a dicing line or to an area near the cross-section of each chip separated by dicing.

If the chip is enclosed in a package while the filament-like dicing debris as the above remains on the chip, then the filament-like dicing debris attached to the chip will be decomposed by heat used for the enclosing and the thermally decomposed substance may destroy the package and/or cause operational failure in a device obtained. Such filament-like dicing debris is difficult to remove by washing and the yield in the dicing step will thus be considerably reduced due to generation of the filament-like dicing debris. Therefore, when a dicing sheet is used to perform dicing, it is needed to prevent the generation of filament-like dicing debris.

To suppress the generation of such dicing debris, Patent Literature 3 discloses an invention which uses, as the base film of a dicing sheet, a polyolefin-based film irradiated with 1 to 80 Mrad of electron rays or γ (gamma) rays. In this invention, it appears that a resin that constitutes the base film is crosslinked through the irradiation with electron rays or γ rays thereby to suppress the generation of dicing debris.

[Prior Art Literature]

[Patent Literature]

[Patent Literature 1] JP2001-207140A
[Patent Literature 2] JP2010-260893A
[Patent Literature 3] JP05-211234A

[Summary of the Invention]

[Problems to be solved by the Invention]

However, when a resin that constitutes the base film is crosslinked through the irradiation with electron rays or $\gamma$ rays, mechanical characteristics of the resin deteriorate and the possibility of fracture of the base film during the expanding step becomes high, which may be problematic.

The present invention has been created in view of such actual circumstances as the above and objects of the present invention include providing a base film for dicing sheets and a dicing sheet which are excellent in the expanding properties and can suppress the occurrence of blocking and reduce the dicing debris generated during the dicing of a cut object.

[Means for solving the Problems]

To achieve the above objects, according to a first aspect of the present invention, there is provided a base film for dicing sheets, the base film being used in a dicing sheet comprising the base film and a pressure sensitive adhesive layer laminated on one surface of the base film, wherein the base film comprises at least a first resin layer (A) that is in contact with the pressure sensitive adhesive layer of the dicing sheet and a second resin layer (B) that comes into contact with the first resin layer (A) when the base film for dicing sheets is wound up, the second resin layer (B) has a crystallinity of 28% to 45%, a ratio of a tensile elastic modulus of the first resin layer (A) to a tensile elastic modulus of the second resin layer (B) is 1.2 to 3.0, and a ratio of a thickness of the first resin layer (A) to a thickness of the base film for dicing sheets is 20% to 60% (Invention 1).

According to the above invention (Invention 1), the above physical properties are satisfied thereby to allow for excellent expanding properties (expandability and recoverability) and suppression of the occurrence of blocking, and the generation of dicing debris during the dicing of a cut object can also be reduced.

In the above invention (Invention 1), a further layer may be laminated between the first resin layer (A) and the second resin layer (B) and in this case it may be preferred that the further layer has a tensile elastic modulus that is not higher than the tensile elastic modulus of the first resin layer (A) (Invention 2).

In the above invention (Invention 1, 2), it may be preferred that at least the first resin layer (A) and the second resin layer (B) contain an olefin-based resin (Invention 3).

In the above invention (Invention 1 to 3), it may be preferred that the second resin layer (B) contains at least one selected from a homopolymer of ethylene and a copolymer of ethylene and (meth)acrylic acid and/or (meth)acrylic ester (Invention 4).

In the above invention (Invention 1 to 4), it may be preferred that the first resin layer (A) comprises, as an example, a resin composition (R1) that contains an ethylene-based copolymer (a1) selected from an ethylene/$\alpha$,$\beta$-unsaturated carboxylic acid copolymer and an ethylene/$\alpha$,$\beta$-unsaturated carboxylic acid/$\alpha$,$\beta$-unsaturated carboxylic ester copolymer, a ternary copolymer (a2) having a constitutional unit originated from $\alpha$-olefin, a constitutional unit originated from glycidyl (meth)acrylate or glycidyl unsaturated ether and a constitutional unit originated from vinyl ester or unsaturated carboxylic ester, and a polyolefin (a3) (Invention 5).

In the above invention (Invention 5), it may be preferred that the ethylene-based copolymer (a1) is an ethylene/(meth) acrylic acid copolymer (Invention 6).

In the above invention (Invention 5, 6), it may be preferred that the ternary copolymer (a2) is an ethylene/glycidyl (meth)acrylate/alkyl acrylate ester copolymer (Invention 7).

In the above invention (Invention 1 to 4), it may be preferred that the first resin layer (A) comprises, as an example, a resin composition (R2) that contains an ethylene/(meth)acrylic acid copolymer (a4) and a polypropylene-based resin (a5) (Invention 8).

In the above invention (Invention 1 to 8), it may be preferred that the second resin layer (B) contains, as an example, an ethylene-based copolymer (b1) that is a copolymer of ethylene and (meth)acrylic acid and/or (meth)acrylic ester (Invention 9).

In the above invention (Invention 9), it may be preferred that the ethylene-based copolymer (b1) is an ethylene/(meth)acrylic acid copolymer (Invention 10).

In the above invention (Invention 1 to 8), it may be preferred that the second resin layer (B) comprises, as an example, a resin composition (R4) that contains a polyethylene-based resin (b2) and a thermoplastic elastomer (b3) (Invention 11).

In the above invention (Invention 1 to 11), it may be preferred that the first resin layer (A) has a tensile elastic modulus of 140 to 400 MPa and the second resin layer (B) has a tensile elastic modulus of 100 to 290 MPa (Invention 12).

In the above invention (Invention 1 to 12), it may be preferred that the base film for dicing sheets is formed by coextrusion molding (Invention 13).

According to a second aspect of the present invention, there is provided a dicing sheet comprising a base film and a pressure sensitive adhesive layer laminated on one surface of the base film, wherein the base film is the base film for dicing sheets (Invention 1 to 13) and the pressure sensitive adhesive layer is laminated so as to be in contact with the first resin layer (A) of the base film for dicing sheets (Invention 14).

[Advantageous Effect of the Invention]

According to the base film for dicing sheets and the dicing sheet of the present invention, the expanding properties are excellent, the occurrence of blocking can be suppressed, and the dicing debris generated during the dicing of a cut object can be reduced. Therefore, when the base film for dicing sheets and the dicing sheet according to the present invention are used, process failure is less likely to occur.

[Brief Description of Drawings]

[FIG. 1] FIG. 1 is a cross-sectional view of a dicing sheet according to an embodiment of the present invention.
[FIG. 2] FIG. 2 is a cross-sectional view of a dicing sheet according to another embodiment of the present invention.

[Embodiments for Carrying out the Invention]

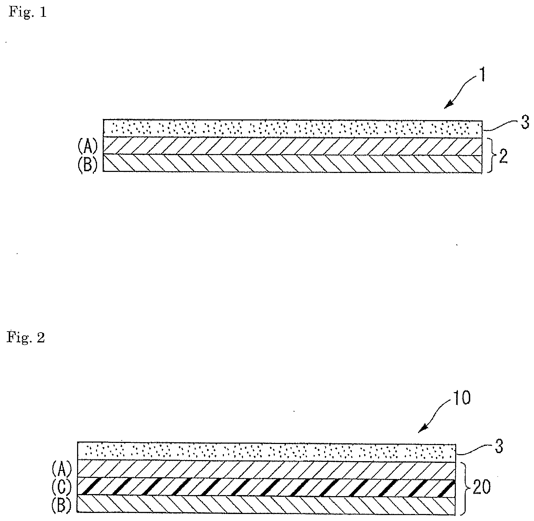

Hereinafter, a base film for dicing sheets (which may be simply referred to as a "base film," hereinafter) and a dicing sheet according to the present invention will be described.
As illustrated in FIG. 1, the dicing sheet 1 according to the present embodiment is configured to comprise a base film 2 according to the present embodiment and a pressure sensitive adhesive layer 3 laminated on one surface (upper surface in FIG. 1) of the base film 2.

1. Base film

The base film 2 according to the present embodiment comprises, as illustrated in FIG. 1, a first resin layer (A) that is in contact with the above pressure sensitive adhesive layer 3 and a second resin layer (B) that is laminated on one surface side (lower surface side in FIG. 1) of the first resin layer (A). When this base film 2 is wound up, the first resin layer (A) and the second resin layer (B) come into contact with each other.
In the above base film 2, the crystallinity of the second resin layer (B) is 28% to 45%, the ratio of a tensile elastic modulus of the first resin layer (A) to a tensile elastic modulus of the second resin layer (B) ((A)/(B)) is 1.2 to 3.0, and the ratio of a thickness of the first resin layer (A) to a thickness of the base film 2 is 20% to 60%. Measurement methods for the crystallinity and tensile elastic modulus are stated in the examples to be described later.
The base film 2 satisfying the above physical properties is excellent in the expanding properties, that is, excellent in the expandability and recoverability during the expanding, and can suppress the occurrence of blocking and reduce the generation of dicing debris during the dicing of a cut object.
Specifically, when the crystallinity of the second resin layer (B) is 28% to 45% and the ratio of a thickness of the first resin layer (A) to a thickness of the base film 2 is 20% to 60%, the base film 2 as a whole can be excellent in the expanding properties. If the crystallinity of the second resin layer (B) is less than 28%, tack will be caused in the second resin layer (B) and the blocking may readily occur because the second resin layer (B) and the first resin layer (A) come into close contact with each other when the base film 2 is wound up. Therefore, when the wound-up base film is wound off, feeding thereof cannot be performed and/or troubles may occur in the feeding. In addition, when the base film 2 is used as a part of the dicing sheet 1, the base film 2 may come into close contact with a dicing table to readily cause transport errors. If the crystallinity of the second resin layer (B) exceeds 45%, the base film 2 will readily fracture during the expanding and/or the recoverability cannot be efficiently ensured.
In view of the above, the crystallinity of the second resin layer (B) may preferably be 29% to 40% and particularly preferably 30 to 35%.
When the ratio of a tensile elastic modulus of the first resin layer (A) to a tensile elastic modulus of the second resin layer (B) is 1.2 to 3.0, the first resin layer (A) can be relatively rigid. Together with this physical property, when the ratio of a thickness of the first resin layer (A) to a thickness of the base film 2 is 20% to 60%, it is possible to suppress the occurrence of blocking and reduce the dicing debris generated during the dicing of a cut object without diminishing the excellent expanding properties by the second resin layer (B). If the above ratio of tensile elastic moduli is less than 1.2, blocking will readily occur and dicing debris will readily be generated during the dicing. If the above ratio of tensile elastic moduli exceeds 3.0, a large strain will be generated between the first resin layer (A) and the second resin layer (B) and the base film 2 may readily delaminate at the time of expanding because stress concentration may occur during the dicing.

In view of the above, the ratio of a tensile elastic modulus of the first resin layer (A) to a tensile elastic modulus of the second resin layer (B) may preferably be 1.2 to 2.5 and particularly preferably 1.2 to 2.0.

When the ratio of a thickness of the first resin layer (A) to a thickness of the base film 2 is 20% to 60%, the above action and effect are exhibited. If the above ratio of thicknesses is less than 20%, dicing debris may be readily generated during the dicing. If the above ratio of thicknesses exceeds 60%, the base film 2 may readily delaminate at the time of expanding in particular because the expanding properties deteriorate.

In view of the above, the ratio of a thickness of the first resin layer (A) to a thickness of the base film 2 may preferably be 25% to 55% and particularly preferably 30% to 50%.

The tensile elastic modulus of the first resin layer (A) may preferably be 140 to 400 MPa, particularly preferably 150 to 350 MPa, and further preferably 160 to 300 MPa. The tensile elastic modulus of the second resin layer (B) may preferably be 100 to 290 MPa, particularly preferably 125 to 240 MPa, and further preferably 130 to 230 MPa. When the tensile elastic moduli of the first resin layer (A) and second resin layer (B) fall within the above ranges, the ratio of a tensile elastic modulus of the first resin layer (A) to a tensile elastic modulus of the second resin layer (B) may readily fall within the above range and it is possible to more enhance the expanding properties, effect of suppressing the occurrence of blocking, and effect of reducing the dicing debris.

The tensile elastic modulus of the base film 2 as a whole may preferably be 100 to 300 MPa, particularly preferably 110 to 280 MPa, and further preferably 120 to 250 MPa. If the tensile elastic modulus of the base film 2 is less than 100 MPa, the base film 2 will get loose because of its flexibility when the dicing sheet 1 is attached to a wafer and fixed to a ring frame, which may possibly cause transport errors. If the tensile elastic modulus exceeds 300 MPa, the load to be applied during the expanding step may have to be increased and problems may occur, including that the dicing sheet 1 itself is detached from the ring frame.

Each of the first resin layer (A) and the second resin layer (B) may preferably contain an olefin-based resin. Examples of the olefin-based resin include: polyolefin such as polyethylene, polypropylene, polybutene, ethylene/propylene copolymer and ethylene/butene copolymer; and copolymer obtained by polymerizing an olefin compound and one or more selected from acrylic compounds. Among them, a polymer of which the constitutional monomer is ethylene may be preferred.

When the first resin layer (A) and the second resin layer (B) each contain the above material, the previously-described physical properties may be readily satisfied and the interfacial adhesion between the first resin layer (A) and the second resin layer (B) can be improved. These resin layers will be described below in detail.

(1) First Resin Layer (A)

The first resin layer (A) may preferably comprise a resin composition (R1) that contains an ethylene-based copolymer (a1) selected from an ethylene/α,β-unsaturated carboxylic acid copolymer and an ethylene/α,β-unsaturated carboxylic acid/α,β-unsaturated carboxylic ester copolymer, a ternary copolymer (a2) having a constitutional unit originated from α-olefin, a constitutional unit originated from glycidyl (meth)acrylate or glycidyl unsaturated ether and a constitutional unit originated from vinyl ester or unsaturated carboxylic ester, and a polyolefin (a3) or may also preferably comprise a resin composition (R2) that contains an ethylene/(meth)acrylic acid copolymer (a4) and a polypropylene-based resin (a5). The first resin layer (A) comprising such a material may particularly readily satisfy the previously-described physical properties and it is possible to more enhance the expanding properties, effect of suppressing the occurrence of blocking, and effect of reducing the dicing debris. As used in the present description, the "(meth)acrylate" is a collective term of acrylate and methacrylate. The same applies to similar terms.

(1-1) Resin Composition (R1)

The resin composition (R1) contains an ethylene-based copolymer (a1), a ternary copolymer (a2), and a polyolefin (a3).

(1-1-1) Ethylene-based Copolymer (a1)

The ethylene-based copolymer (a1) is at least one selected from an ethylene/α,β-unsaturated carboxylic acid copolymer and an ethylene/α,β-unsaturated carboxylic acid/α,β-unsaturated carboxylic ester copolymer.

The ethylene/α,β-unsaturated carboxylic acid copolymer is a polymer that is obtained by copolymerizing ethylene and a monomer selected from α,β-unsaturated carboxylic acids, at least as the copolymerization components. The ethylene/α,β-unsaturated carboxylic acid/α,β-unsaturated carboxylic ester copolymer is a polymer that is obtained by copolymerizing ethylene, a monomer selected from α,β-unsaturated carboxylic acids, and a monomer selected from α,β-unsaturated carboxylic esters, at least as the copolymerization components. In the ethylene/α,β-unsaturated carboxylic acid copolymer, other monomers than ethylene and unsaturated carboxylic acid may be copolymerized, if necessary. In the ethylene/α,β-unsaturated carboxylic acid/α,β-unsaturated carboxylic ester copolymer, other monomers than ethylene, unsaturated carboxylic acid and unsaturated carboxylic ester may be copolymerized, if necessary.

The copolymer may be any of block copolymer, random copolymer, or graft copolymer. Among them, a binary random copolymer or ternary random copolymer may be preferred in view of the reactivity with glycidyl (meth)acrylate or glycidyl unsaturated ether and the industrial availability.

Examples of the α,β-unsaturated carboxylic acid, which constitutes the ethylene/α,β-unsaturated carboxylic acid copolymer or the ethylene/α,β-unsaturated carboxylic acid/α,β-unsaturated carboxylic ester copolymer, include unsaturated carboxylic acids of which the carbon number is 4 to 8, such as acrylic acid, methacrylic acid, ethacrylic acid, itaconic acid, itaconic acid anhydride, fumaric acid, crotonic acid, maleic acid, maleic acid anhydride, maleic monoester (such as monomethyl maleate and monoethyl maleate), and maleic monoester anhydride (such as monomethyl maleate anhydride and monoethyl maleate anhydride). Salts of unsaturated carboxylic acid are also included.

Among the above, acrylic acid, methacrylic acid, maleic acid, maleic acid anhydride, maleic monoester and maleic monoester anhydride may be preferred and acrylic acid and methacrylic acid may be particularly preferred.

Examples of the α,β-unsaturated carboxylic ester, which constitutes the ethylene/α,β-unsaturated carboxylic acid/α,β-unsaturated carboxylic ester copolymer, include alkyl esters, of which the carbon number is 1 to 8, of unsaturated carboxylic acids, such as acrylic alkyl ester, methacrylic alkyl ester, ethacrylic alkyl ester, crotonic alkyl ester, fumaric alkyl ester, maleic alkyl ester, maleic monoalkyl ester, maleic alkyl ester anhydride, itaconic alkyl ester, and itaconic alkyl ester anhydride. When containing such constitutional units originated and delivered from α,β-unsaturated carboxylic esters, the obtained copolymer can have improved flexibility, which may be preferred.

Examples of the alkylated site of the above alkyl ester include those of which the carbon number is 1 to 12, more specifically alkyl groups such as methyl, ethyl, n-propyl, isopropyl, n-butyl, isobutyl, secondary butyl, 2-ethylhexyl, and isooctyl. Among them, alkyl esters having alkylated sites of which the carbon number is 1 to 8 may be preferred.

In particular, methyl ester, ethyl ester, normal butyl ester and isobutyl ester of acrylic acid or methacrylic acid may be preferred as the above α,β-unsaturated carboxylic ester.

Specific examples of the ethylene/α,β-unsaturated carboxylic acid copolymer include ethylene/acrylic acid copolymer and ethylene/methacrylic acid copolymer. Commercially available products put on the market as the ethylene/α,β-unsaturated carboxylic acid copolymer may also be used. Examples of such commercially available products to be used include Nucrel series (product name) available from DUPONT-MITSUI POLYCHEMICALS CO., LTD.

Content ratio (mass ratio) of the constitutional units originated from α,β-unsaturated carboxylic acid in the ethylene/α,β-unsaturated carboxylic acid copolymer may preferably be 1 to 20 mass% and more preferably 5 to 20%. This can improve the blocking resistance of the obtained copolymer.

Specific examples of the ethylene/α,β-unsaturated carboxylic acid/α,β-unsaturated carboxylic ester copolymer include ethylene/(meth)acrylic acid/(meth)acrylic ester copolymers as preferred examples, among which ethylene/(meth)acrylic acid/methyl acrylate copolymer, ethylene/(meth)acrylic acid/ethyl acrylate copolymer, ethylene/(meth)acrylic acid/normal-butyl acrylate copolymer, ethylene/(meth)acrylic acid/isobutyl acrylate copolymer, ethylene/(meth)acrylic acid/methyl methacrylate copolymer, ethylene/(meth)acrylic acid/ethyl methacrylate copolymer, ethylene/(meth)acrylic acid/normal-butyl methacrylate copolymer, and ethylene/(meth)acrylic acid/isobutyl methacrylate copolymer may be preferred. Among them, copolymers of ethylene/(meth)acrylic acid/alkyl (meth) acrylate of which the carbon number is 1 to 8 (preferably 1 to 4) may be particularly preferred.

Content ratio (mass ratio) of the constitutional units originated from α,β-unsaturated carboxylic acid in the ethylene/α,β-unsaturated carboxylic acid/α,β-unsaturated carboxylic ester copolymer may preferably be 1 to 20 mass% and more preferably 5 to 20%. This can improve the blocking resistance of the obtained copolymer.

In consideration of a more significant effect of improving the blocking resistance, it may be more preferred that the ethylene-based copolymer contains the ethylene/α,β-unsaturated carboxylic acid copolymer rather than the ethylene/α,β-unsaturated carboxylic acid/α,β-unsaturated carboxylic ester copolymer, among the above.

Content ratio (mass ratio) of the constitutional units originated from α,β-unsaturated carboxylic ester in the ethylene/α,β-unsaturated carboxylic acid/α,β-unsaturated carboxylic ester copolymer may preferably be 1 to 20 mass% and more preferably 3 to 18% to the total mass of the copolymer. This can suppress the blocking more effectively.

Melt mass flow rate (MFR) of the ethylene-based copolymer (a1) may preferably be 2 to 500 g/10 min, particularly preferably 2 to 150 g/10 min, and further preferably 2 to 120 g/10 min. The melt mass flow rate being within the above range is advantageous in the film moldability. The MFR of the ethylene-based copolymer (a1) and those of a ternary copolymer (a2) and a mixed resin obtained by melting and mixing three components (a1) to (a3) to be described later may be values that are measured at 190°C and 2.16 kgf using a method in accordance with JIS K7210-1999.

Content of the ethylene-based copolymer (a1) in the resin composition (R1) may preferably be 50 to 99 mass%, more preferably 50 to 94.5 mass%, particularly preferably 50 to 85 mass%, and further preferably 60 to 85 mass%, to the total amount of the resin composition (R1).

EP 3 147 936 A1

(1-1-2) Ternary Copolymer (a2)

The ternary copolymer (a2) has a constitutional unit originated from α-olefin, a constitutional unit originated from glycidyl (meth)acrylate or glycidyl unsaturated ether, and a constitutional unit originated from vinyl ester or unsaturated carboxylic ester. That is, the ternary copolymer (a2) is a copolymer that is obtained at least by copolymerizing α-olefin (preferably ethylene), glycidyl (meth)acrylate or glycidyl unsaturated ether, and vinyl ester or unsaturated carboxylic ester. If necessary, other monomers may be further copolymerized.

Examples of the α-olefin include α-olefins of which the carbon number is 2 to 10 (such as ethylene, propylene, 1-butene, 1-pentene, 1-hexene, 4-methyl-1-pentene, 3-methyl-1-butene and 1-octene, for example), among which ethylene and propylene may be preferred.

Examples of the glycidyl (meth)acrylate or glycidyl unsaturated ether include glycidyl acrylate, glycidyl methacrylate, vinylglycidylether, allylglycidylether, and 2-methylallylglycidylether.

Examples of the vinyl ester include vinyl acetate and vinyl propionate.

Examples of the unsaturated carboxylic ester include esters of the α,β-unsaturated carboxylic acid in the above ethylene-based copolymer (a1). Preferred ones may be lower alkyl esters, of which the carbon number is 2 to 5, of the above α,β-unsaturated carboxylic acid and further preferred ones may be alkyl esters of which the carbon number is 4, such as isobutyl and n-butyl esters, of the above α,β-unsaturated carboxylic acid.

Examples of the unsaturated carboxylic ester include ester compounds such as methyl acrylate, ethyl acrylate, isopropyl acrylate, isobutyl acrylate, n-butyl acrylate, isooctyl acrylate, methyl methacrylate, isobutyl methacrylate, and dimethyl maleate. Among them, lower alkyl esters (carbon number of 2 to 5) of acrylic acid or methacrylic acid may be preferred, such as methyl acrylate, ethyl acrylate, isopropyl acrylate, isobutyl acrylate, n-butyl acrylate, methyl methacrylate, and isobutyl methacrylate. Further, n-butyl esters and isobutyl esters of acrylic acid or methacrylic acid may be preferred, among which alkyl esters having a carbon number of 4 of acrylic acid may be preferred and isobutyl esters may be particularly preferred.

The ratio (mass ratio) of constitutional units originated from the α-olefin in the ternary copolymer (a2) may preferably be 40 to 99 mass% and more preferably 50 to 98 mass% to the total mass of the ternary copolymer (a2).

The ratio (mass ratio) of constitutional units originated from the glycidyl (meth) acrylate or glycidyl unsaturated ether in the ternary copolymer (a2) may preferably be 0.5 to 20 mass% and more preferably 1 to 15 mass% to the total mass of the ternary copolymer (a2). When the ratio of constitutional units originated from the glycidyl (meth)acrylate or glycidyl unsaturated ether is 0.5 mass% or more, the effect of improving the blocking resistance is large. When the ratio of constitutional units originated from the glycidyl (meth) acrylate or glycidyl unsaturated ether is 20 mass% or less, the reaction with the unsaturated carboxylic acid is not excessively strong. Therefore, the rapid increase in the resin viscosity can be suppressed to maintain the moldability and prevent the generation of gels in the composition.

The ratio (mass ratio) of constitutional units originated from the vinyl ester or unsaturated carboxylic ester in the ternary copolymer (a2) may preferably be 1 to 40 mass% to the total mass of the ternary copolymer. When the ratio of constitutional units originated from the vinyl ester or unsaturated carboxylic ester is 40 mass% or less, appropriate flexibility can be obtained and excellent blocking resistance can also be obtained because the tack is suppressed. The ratio being 1 mass% or more means that the constitutional units originated from the vinyl ester or unsaturated carboxylic ester are contained in a positive manner.

The ternary copolymer (a2) may be any of a random copolymer or graft copolymer. In general, a random copolymer may be preferred because of the homogeneity in the reaction with the ethylene/α,β-unsaturated carboxylic acid copolymer. Such a random copolymer may be obtained, for example, by radical copolymerization under a high temperature and high pressure.

Melt mass flow rate (MFR) of the ternary copolymer (a2) may preferably be 0.01 to 1,000 g/10 min and particularly preferably 0.1 to 200 g/10 min. The melt mass flow rate being within the above range is advantageous in the blocking resistance because the degree of crosslinking is enhanced.

The content of the ternary copolymer (a2) in the resin composition (R1) may preferably be 0.1 to 10 mass%, more preferably 0.5 to 10 mass%, particularly preferably 1 to 10 mass%, and further preferably 1 to 8 mass%, to the total amount of the resin composition (R1).

(1-1-3) Polyolefin (a3)

When the resin composition (R1) contains the polyolefin (a3), dispersibility of other components is improved and the resin composition (R1) can be obtained with excellent blocking resistance.

Examples of the polyolefin (a3) include homopolymers and copolymers of α-olefin of which the carbon number is 2 to 10 (such as ethylene, propylene, 1-butene, 1-pentene, 1-hexene, 4-methyl-1-pentene, 3-methyl-1-butene and 1-octene, for example), and those manufactured by various methods using various catalysts can be used. More specific examples of polyolefin include polyethylene, polypropylene, polybutene-1, and poly-4-methyl-1-pentene.

Low-density polyethylene (LDPE) and linear low-density polyethylene (LLDPE) may be preferred as the above polyethylene. Among the linear low-density polyethylenes, linear low-density polyethylene manufactured using a homogeneous catalyst such as metallocene catalyst may be particularly preferred.

Examples of the above polypropylene include polymers selected from propylene homopolymers and propylene-based copolymers obtained by copolymerization of propylene and other monomers.

Examples of the above propylene-based copolymers include, for example, random copolymers, block copolymers and alternate copolymers of propylene and ethylene and/or α-olefin other than ethylene (the carbon number is preferably 4 to 8). Among them, homopolymers and random copolymers may be preferred.

In view of the blocking resistance, among the above, random polypropylene, homopolypropylene, low-density polyethylene and linear low-density polyethylene may be preferred as the polyolefin.

Melt mass flow rate (MFR) of the polyolefin (a3) may preferably be 0.5 to 100 g/10 min, more preferably 1 to 50 g/10 min, and particularly preferably 1 to 20 g/10 min. The MFR of the polyolefin (a3) may be a value that is measured at 230°C and 2.16 kgf using a method in accordance with JIS K7210-1999.

The content of the polyolefin (a3) in the resin composition (R1) may preferably be 0.5 to 40 mass%, more preferably 5 to 40 mass%, and particularly preferably 10 to 35 mass%, to the total amount of the resin composition (R1).

In the resin composition (R1), it may be particularly preferred that the content ratio of the ethylene-based copolymer (a1) is 50 to 94.5 mass%, the content ratio of the ternary copolymer (a2) is 0.5 to 10 mass%, and the content ratio of the polyolefin (a3) is 5 to 40 mass%. The content ratio of the ternary copolymer (a2) being 0.5 mass% or more is advantageous in obtaining more excellent blocking resistance. The content ratio of the ternary copolymer (a2) being 10 mass% or less is advantageous in that the reaction with the ethylene-based copolymer is not excessively strong and moderate viscosity can thus be maintained to suppress the generation of gels in the composition. The content ratio of the polyolefin (a3) being 5 mass% or more is advantageous in the blocking resistance. The content ratio of the polyolefin (a3) being 40 mass% or less is advantageous in the dispersibility with other components. In the resin composition (R1), it may be further preferred that the content ratio of the ethylene-based copolymer (a1) is 55 to 89 mass%, the content ratio of the ternary copolymer (a2) is 1 to 10 mass%, and the content ratio of the polyolefin (a3) is 10 to 35 mass%.

The resin composition (R1) can be obtained by melting and mixing the ethylene-based copolymer (a1), ternary copolymer (a2), and polyolefin (a3). When melting and mixing them, an ordinarily-used mixing apparatus, such as a screw extruder, roll mixer and Banbury mixer, can be used. The melting and mixing may be performed by compounding the three components (a1) to (a3) at once.

Among the above, a preferred method may include preliminarily melting and mixing the ternary copolymer (a2) and polyolefin (a3) and further melting and mixing the molten mixture obtained by the melting and mixing and the ethylene-based copolymer (a1). According to this method, the ternary copolymer (a2) is diluted with the polyolefin (a3) thereby to allow the reaction with the ethylene-based copolymer (a1) to progress homogeneously without occurring locally, and therefore a composition having excellent properties can advantageously be manufactured with good quality stability. On the other hand, according to a method that includes melting and mixing the ethylene-based copolymer (a1) and ternary copolymer (a2) first and then mixing the polyolefin (a3), unfortunately, the reaction may progress locally to generate gels. When melting and mixing the above three components (a1) to (a3) at once, it may be preferred to use a biaxial extruder to perform the melting and mixing.

Melt mass flow rate (MFR) of the mixed resin obtained by melting and mixing the above three components (a1) to (a3) may preferably be 0.2 to 3.1 g/10 min, more preferably 0.2 to 2.5 g/10 min, and particularly preferably 0.2 to 2.0 g/10 min, in view of the fusion bonding resistance when the components are formed into a molded body.

The resin composition (R1) may contain various additives, such as pigment, flame retardant, plasticizer, antistatic, glidant and filler, in addition to the above three components (a1) to (a3). Examples of the pigment include titanium dioxide and carbon black. Examples of the filler include organic materials such as melamine resin, inorganic materials such as fumed silica, and metal-based materials such as nickel particles. The content of such additives is not particularly limited, but should be within a range in which the first resin layer (A) can exhibit desired functionality and does not lose the smoothness and flexibility.

(1-2) Resin Composition (R2)

The resin composition (R2) contains an ethylene/(meth)acrylic acid copolymer (a4) and a polypropylene-based resin (a5). The resin composition (R2) containing the ethylene/ (meth) acrylic acid copolymer (a4) can exhibit the expandability and recoverability during the expanding. The resin composition (R2) contains the polypropylene-based resin (a5) thereby to have an effect of preventing the blocking when the film is wound up. Moreover, it is possible to adjust the elastic modulus of the base film as a whole and a subsidiary effect can be obtained for suppressing the dicing debris.

(1-2-1) Ethylene/(Meth)acrylic Acid Copolymer (a4)

The ethylene/(meth)acrylic acid copolymer (a4) is a copolymer of ethylene and (meth)acrylic acid. Methacrylic acid may be particularly preferred as the (meth) acrylic acid. The copolymer may be any of a block copolymer, random copolymer, or graft copolymer.

The content ratio of constitutional units originated from (meth)acrylic acid in the ethylene/ (meth) acrylic acid copolymer (a4) may preferably be 2 to 14 mass%, more preferably 4 to 12 mass%, and particularly preferably 5 to 10 mass%, as a mass ratio of (meth)acrylic acid to the whole monomers for forming the copolymer. If the above mass ratio of (meth) acrylic acid exceeds 14 mass%, the crystallinity of the ethylene/ (meth) acrylic acid copolymer (a4) will deteriorate to cause sticking at ordinary temperatures, which may negatively affect the blocking when the film is wound up. If the above mass ratio of (meth)acrylic acid is less than 2 mass%, the crystallinity of the first resin layer (A) will increase and it may thus be difficult to exhibit the expandability and recoverability during the expanding.

The ethylene/(meth)acrylic acid copolymer (a4) may contain constitutional units originated from other compounds in addition to those originated from ethylene, acrylic acid and/or methacrylic acid to an extent that does not impair the objects of the dicing sheet 1 according to the present embodiment. Examples of such other compounds include: $\alpha$-olefin such as propylene; and (meth)acrylic ester such as methyl (meth)acrylate and ethyl (meth)acrylate. The content ratio of such constitutional units originated from other compounds may preferably be a ratio of less than 10 mass% as a mass ratio of these other compounds to the whole monomers for forming the copolymer.

The tensile elastic modulus of the ethylene/(meth)acrylic acid copolymer (a4) may preferably be 80 to 250 MPa, more preferably 120 to 230 MPa, and particularly preferably 150 to 200 MPa, in view of giving the expandability and recoverability during the expanding.

The content of the ethylene/ (meth) acrylic acid copolymer (a4) in the resin composition (R2) may preferably be 60 to 95 mass%, particularly preferably 70 to 93 mass%, and further preferably 75 to 90 mass%. If the content of the ethylene/(meth)acrylic acid copolymer (a4) exceeds 15 mass%, the pressure sensitive adhesion property of the ethylene/(meth)acrylic acid copolymer (a4) alone will be excessively high and troubles (such as deterioration in the workability) may possibly occur when the resin composition (R2) is molded into a film-like shape to form the first resin layer (A). If the content of the ethylene/(meth) acrylic acid copolymer (a4) is less than 2 mass%, the flexibility of the first resin layer (A) as a whole will be lost and troubles (such as fracture of the base film 2) may possibly occur during the expanding step.

(1-2-2) Polypropylene-based Resin (a5)

Propylene-based polymer of the polypropylene-based resin (a5) may be a homopolymer of propylene or may also be a copolymer of propylene and other compounds having ethylenically unsaturated bonds. In the present description, compounds that are contained in the propylene-based polymer of the polypropylene-based resin (a5) and have ethylenically unsaturated bonds to give constitutional units other than the constitutional units originated from propylene are also referred to as "other unsaturated compounds." In view of stably obtaining properties as those of polypropylene, preferred examples of the other unsaturated compounds include $\alpha$-olefin and ethylene. As the $\alpha$-olefin, there may be exemplified an alkene which has a double bond at the $\alpha$-site and of which the carbon number is 4 to 18, such as 1-butene, 1-hexene, and 1-octene.

When the propylene-based polymer of the polypropylene-based resin (a5) is a copolymer of propylene and other unsaturated compounds, the content ratio of constitutional units originated from propylene in the copolymer may ordinarily be 75 to 99.9 mass%, preferably 80 to 99 mass%, more preferably 85 to 99 mass%, and further preferably 90 to 99 mass%, as a mass ratio of propylene to the whole monomers for forming the copolymer. When the propylene-based polymer of the polypropylene-based resin (a5) contains a copolymer in which the above mass ratio of propylene is 75 mass% or more, the generation of dicing debris at the time of processing the dicing sheet 1 can be more stably suppressed.

When the propylene-based polymer of the polypropylene-based resin (a5) contains a copolymer, the specific form of the copolymer is not particularly limited and it may be any of a random copolymer, block copolymer, and graft copolymer. The propylene-based polymer may contain two or more types of such copolymers. Among these forms, a random copolymer may be preferred because the possibility of generation of dicing debris during the dicing step can be more stably reduced.

The polypropylene-based resin (a5) may preferably be a thermoplastic resin in view of easily manufacturing the first resin layer (A), etc. In this case, the propylene-based polymer of the polypropylene-based resin (a5) may be in a state in which it is not crosslinked or the degree of crosslinking is appropriately controlled. When the polypropylene-based resin (a5) is a thermoplastic resin, the melt mass flow rate (MFR) when measured at a temperature of 230°C and a load of 2.16 kgf (in accordance with JIS K7210-1999) may preferably be 0.5 to 10 g/10 min and more preferably 2.0 to 7.0 g/10 min.

When the polypropylene-based resin (a5) is a thermoplastic resin and crystalline, the melting peak temperature may preferably be 125°C to 170 °C and more preferably 130°C to 165°C. If the melting peak temperature of the polypropylene-based resin (a5) is lower than 125°C, the generation of dicing debris may not be readily suppressed because the content of propylene monomers that constitute the polypropylene-based resin (a5) may be small. If the melting peak temperature of the polypropylene-based resin (a5) exceeds 170°C, the molecular weight of the propylene-based polymer of the polypropylene-based resin (a5) may be excessively large and concerns are that it will be difficult to make the first resin layer (A) thin when molding the resin composition for forming the first resin layer (A) (resin composition (R2)) into a film-like shape and variation may occur in its thickness.

When the polypropylene-based resin (a5) is a thermoplastic resin and crystalline, the melting heat quantity may preferably be 70 to 110 J/g. If the melting heat quantity of the polypropylene-based resin (a5) is less than 70 J/g, the generation of dicing debris during the dicing step may not be readily suppressed because the crystallinity of the propylene-based polymer of the polypropylene-based resin (a5) may be small. In addition, the pressure sensitive adhesion property of the polypropylene-based resin (a5) alone will be excessively high and troubles (such as deterioration in the workability) may possibly occur when the resin composition for forming the first resin layer (A) is molded into a film-like shape. If the melting heat quantity of the polypropylene-based resin (a5) exceeds 110 J/g, the crystallinity of the propylene-based polymer of the polypropylene-based resin (a5) will be high to reduce the flexibility of the first resin layer (A) as a whole and troubles (such as fracture of the base film 2) may possibly occur during the expanding step.

The melting peak temperature and melting heat quantity $\Delta H$ in the present description refer to values that are obtained using a differential scanning calorimeter (model number: Q2000 available from TA Instruments was used in the exemplary test). Specifically, they may be measured in a manner as below. That is, after heating is performed at a heating rate of 20°C/min from -50°C to 250°C, rapid cooling is performed to -50°C from which heating is performed again at a heating rate of 20°C/min to 250°C, and the temperature is maintained. The peak temperature obtained in the second heating measurement is employed as the melting peak temperature. The melting heat quantity $\Delta H$ is calculated from data obtained when cooling is performed thereafter at a heating rate of 20°C/min from 250°C to -50°C.

The tensile elastic modulus of the polypropylene-based resin (a5) may preferably be 600 to 999 MPa, more preferably 650 to 990 MPa, and particularly preferably 700 to 990 MPa, in view of suppressing the generation of dicing debris during the dicing step.

The content of the polypropylene-based resin (a5) in the resin composition (R2) may preferably be 5 to 40 mass%, particularly preferably 7 to 30 mass%, and further preferably 10 to 25 mass%. If the content of the polypropylene-based resin (a5) exceeds 40 mass%, the flexibility of the first resin layer (A) as a whole will be lost and troubles (such as fracture of the base film 2) may possibly occur during the expanding step. If the content of the polypropylene-based resin (a5) is less than 5 mass%, the generation of dicing debris may not be readily suppressed.

The resin composition (R2) can be obtained by melting and mixing the ethylene/(meth)acrylic acid copolymer (a4) and the polypropylene-based resin (a5). The method of melting and mixing is the same as the previously-described method.

The resin composition (R2) may contain other polymers and/or various additives as in the resin composition (R1) in addition to the above two components (a4) and (a5).

(1-3) Thickness of First Resin Layer (A)

The thickness of the first resin layer (A) may preferably be 10 to 120 $\mu$m, particularly preferably 20 to 100 $\mu$m, and further preferably 30 to 80 $\mu$m. When the thickness of the first resin layer (A) is 10 $\mu$m or more, the generation of dicing debris can be effectively suppressed during the dicing. When the thickness of the first resin layer (A) is 120 $\mu$m or less, the expanding properties of the base film 2 may be readily maintained at high level.

In the present embodiment, the first resin layer (A) is composed of one resin layer, but the first resin layer (A) may also have a structure comprising a plurality of resin layers. In this case, each layer that constitutes the first resin layer (A) may have the previously-described physical properties and compositional features of the first resin layer (A).

(2) Second Resin Layer (B)

As previously described, the second resin layer (B) may preferably contain a polymer of which the constitutional monomer is ethylene. The polymer of which the constitutional monomer is ethylene may preferably be one selected from a homopolymer of ethylene (polyethylene) and a copolymer of ethylene and (meth)acrylic acid and/or (meth)acrylic ester. In particular, the second resin layer (B) may preferably comprise a resin composition (R3) that contains a copolymer of ethylene and (meth)acrylic acid and/or (meth)acrylic ester (which may be referred to as an "ethylene-based copolymer (b1)") or a resin composition (R4) that contains a polyethylene-based resin (b2) and a thermoplastic elastomer (b3).

(2-1) Resin Composition (R3)

The resin composition (R3) contains an ethylene-based copolymer (b1) that is a copolymer of ethylene and (meth) acrylic acid and/or (meth)acrylic ester. Specifically, the resin composition (R3) may contain, as the ethylene-based copolymer (b1), an ethylene/(meth)acrylic acid copolymer and/or an ethylene/(meth)acrylic ester copolymer, preferably an ethylene/(meth)acrylic acid copolymer, and particularly preferably an ethylene/methacrylic acid copolymer. According to the ethylene-based copolymer (b1), the second resin layer (B) having an excellent toughness can be readily obtained and the interfacial adhesion of the second resin layer (B) to the first resin layer (A) can also be enhanced.

The content ratio of constitutional units originated from (meth)acrylic acid in the above ethylene/(meth)acrylic acid copolymer may preferably be 2 to 20 mass%, more preferably 4 to 15 mass%, and particularly preferably 5 to 12 mass%, as a mass ratio of (meth)acrylic acid to the whole monomers for forming the copolymer. If the above mass ratio of (meth) acrylic acid is less than 2 mass%, the crystallinity of the second resin layer (B) will increase to cause necking of the base film 2 during the expanding after the dicing and the chip intervals may not be expanded uniformly. If the above mass ratio of (meth) acrylic acid exceeds 20 mass%, tack may occur in the second resin layer (B) itself and concern is that the dicing sheet 1 cannot be transported when performing the dicing using an apparatus.

The ethylene/(meth)acrylic acid copolymer may contain constitutional units originated from other compounds in addition to those originated from ethylene, acrylic acid and/or methacrylic acid to an extent that does not impair the objects of the dicing sheet 1 according to the present embodiment. Examples of such other compounds include: α-olefin such as propylene; and (meth)acrylic ester such as methyl (meth) acrylate and ethyl (meth) acrylate. The content ratio of such constitutional units originated from other compounds may preferably be a ratio of less than 10 mass% as a mass ratio of these other compounds to the whole monomers for forming the copolymer.

(Meth)acrylic alkyl ester may be preferred as the (meth) acrylic ester in the above ethylene/ (meth) acrylic ester copolymer, and (meth)acrylic alkyl ester of which the carbon number of alkyl group is 1 to 20 may be particularly preferred. Examples of the (meth)acrylic alkyl ester of which the carbon number of alkyl group is 1 to 20 include, for example, methyl (meth)acrylate, ethyl (meth)acrylate, propyl (meth)acrylate, n-butyl (meth)acrylate, n-pentyl (meth)acrylate, n-hexyl (meth)acrylate, 2-ethylhexyl (meth)acrylate, isooctyl (meth)acrylate, n-decyl (meth)acrylate, n-dodecyl (meth)acrylate, myristyl (meth)acrylate, palmityl (meth)acrylate, and stearyl (meth)acrylate. Among them, (meth)acrylic ester of which the carbon number of alkyl group is 1 to 8 may be preferred, and (meth)acrylic ester of which the carbon number of alkyl group is 1 to 6 may be particularly preferred, in view of the expandability and recoverability during the expanding. They may be used alone or two or more types may be used in combination.

The content ratio of constitutional units originated from (meth)acrylic ester in the ethylene/ (meth) acrylic ester copolymer may preferably be 2 to 20 mass%, more preferably 4 to 15 mass%, and particularly preferably 5 to 12 mass%, as a mass ratio of (meth)acrylic ester to the whole monomers for forming the copolymer. If the above mass ratio of (meth) acrylic ester is less than 2 mass%, the expandability and recoverability as required during the expanding may possibly be impaired. If the above mass ratio of (meth) acrylic ester exceeds 20 mass%, sticking of resin itself will be strong and blocking may possibly occur, such as when winding up the film.

The ethylene/ (meth) acrylic ester copolymer may contain constitutional units originated from other compounds in addition to those originated from ethylene, acrylic acid and/or methacrylic acid to an extent that does not impair the objects of the dicing sheet 1 according to the present embodiment. Examples of such other compounds include α-olefin, such as propylene, and (meth)acrylic acid. The content ratio of such constitutional units originated from other compounds may preferably be a ratio of less than 10 mass% as a mass ratio of these other compounds to the whole monomers for forming the copolymer.

The content of the ethylene-based copolymer (b1) in the resin composition (R3) may preferably be 70 mass% or more, more preferably 80 mass% or more, and further preferably 90 mass% or more.

The resin composition (R3) may contain various additives, such as pigment, flame retardant, plasticizer, antistatic, glidant and filler, in addition to the above ethylene-based copolymer (b1). Examples of the pigment include titanium dioxide and carbon black. Examples of the filler include organic materials such as melamine resin, inorganic materials such as fumed silica, and metal-based materials such as nickel particles. The content of such additives is not particularly limited, but should be within a range in which the second resin layer (B) can exhibit desired functionality and does not lose the smoothness and flexibility.

(2-2) Resin Composition (R4)

The resin composition (R4) contains a polyethylene-based resin (b2) and a thermoplastic elastomer (b3). The resin composition (R4) contains the polyethylene-based resin (b2) thereby to have flexibility while suppressing the blocking when winding up the film. In addition, the resin composition (R4) contains the thermoplastic elastomer (b3) thereby to give the stretching properties and flexibility to the second resin layer (B) and excellent expanding properties can thus be obtained.

(2-2-1) Polyethylene-based Resin (b2)

Specific examples of ethylene-based polymer of the polyethylene-based resin (b2) include a homopolymer of ethylene and ethylene copolymers, such as an ethylene/$\alpha$-olefin copolymer, ethylene/vinyl acetate copolymer, ethylene/(meth)acrylic acid copolymer, and ethylene/(meth)acrylic ester copolymer. The ethylene-based polymer of the polyethylene-based resin (b2) may be composed of a homopolymer that comprises one type of monomer or may also be composed of a copolymer that comprises a plurality of types of monomers. Among the above, low-density polyethylene and linear low-density polyethylene may be preferred and linear low-density polyethylene may be particularly preferred.

The content ratio of constitutional units originated from ethylene in the ethylene-based polymer of the polyethylene-based resin (b2) may ordinarily be 70 mass% or more, preferably 70 to 99.9 mass%, more preferably 80 to 99 mass%, and particularly preferably 90 to 98 mass%, as a mass ratio of ethylene to the whole monomers for forming the copolymer. When the ethylene-based polymer of the polyethylene-based resin (b2) contains an ethylene copolymer of which the above mass ratio of ethylene falls within the above range, the expandability and recoverability as required during the expanding can be exhibited while suppressing the sticking of the resin itself.

Density of the ethylene-based polymer of the polyethylene-based resin (b2) (the "density" refers to a density at 23°C unless otherwise stated in the present description) may preferably be 0.87 to 0.93 g/cm$^3$ and more preferably 0.89 to 0.92 g/cm$^3$. When the density of the ethylene-based polymer is 0.87 g/cm$^3$ or more, the pressure sensitive adhesion property of the second resin layer (B) can be suppressed and the blocking can thus be effectively suppressed. When the density of the ethylene-based polymer is 0.93 g/cm$^3$ or less, the flexibility of the second resin layer (B) can be maintained to ensure the expanding properties of the base film 2.

The polyethylene-based resin (b2) may preferably be a thermoplastic resin, in which case the ethylene-based polymer of the polyethylene-based resin (b2) may be in a state in which it is not crosslinked or the degree of crosslinking is appropriately controlled. When the polyethylene-based resin (b2) is a thermoplastic resin, the melt mass flow rate (MFR) when measured at a temperature of 190°C and a load of 2.16 kgf (in accordance with JIS K7210-1999) may preferably be 0.5 to 10 g/10 min and more preferably 2.0 to 7.0 g/10 min.

When the polyethylene-based resin (b2) is a thermoplastic resin and crystalline, the melting peak temperature may preferably be 90°C to 140°C and more preferably 100°C to 130°C. The melting heat quantity of the polyethylene-based resin (b2), which is a thermoplastic resin and crystalline, may preferably be 50 to 160 J/g. If the melting peak temperature of the polyethylene-based resin (b2) is lower than 90°C and/or if the melting heat quantity is less than 50 J/g, the pressure sensitive adhesion property of the polyethylene-based resin (b2) alone will be excessively high and troubles (such as deterioration in the workability) may possibly occur when the resin composition for forming the second resin layer (B) is molded into a film-like shape. If the melting peak temperature of the polyethylene-based resin (b2) exceeds 140°C and/or if the melting heat quantity exceeds 160 J/g, the crystallinity of the second resin layer (B) will possibly be beyond the previously-described range. The melting peak temperature and the melting heat quantity can be measured using a differential scanning calorimeter, as previously described.

The polyethylene-based resin (b2) may be one type of ethylene-based polymer or may also be a mixture of plural types of ethylene-based polymers.

The content of the polyethylene-based resin (b2) in the resin composition (R4) may preferably be 50 to 90 mass%, particularly preferably 55 to 85 mass%, and further preferably 60 to 80 mass%. When the content of the polyethylene-based resin (b2) is 50 mass% or more, the blocking when winding up the film and/or in a semiconductor working process can be suppressed while ensuring the flexibility. When the content of the polyethylene-based resin (b2) is 90 mass% or less, the content of the thermoplastic elastomer (b3) can be ensured to obtain more excellent expanding properties.

(2-2-2) Thermoplastic Elastomer (b3)

Examples of the thermoplastic elastomer (b3) include olefin-based elastomer, polyester-based elastomer and styrene-based elastomer, among which olefin-based elastomer may be preferred.

As used in the present description, the "olefin-based elastomer" refers to a material that is a copolymer including constitutional units originated from olefin or its derivatives (olefin-based compounds) and has rubber-like elasticity within a temperature range including ordinary temperatures while having thermoplasticity.

Examples of the olefin-based elastomer include those that contain at least one type of resin selected from the group consisting of an ethylene/$\alpha$-olefin copolymer, propylene/$\alpha$-olefin copolymer, butene/$\alpha$-olefin copolymer, ethylene/propylene/$\alpha$-olefin copolymer, ethylene/butene/$\alpha$-olefin copolymer, propylene/butene/$\alpha$-olefin copolymer, ethylene/propylene/butene/$\alpha$-olefin copolymer, styrene/isoprene copolymer, and styrene/ethylene/butylene copolymer. Among them, the ethylene/$\alpha$-olefin copolymer may preferably be used in view of the use after being blended with the polyethylene-based resin (b2) and improving the expandability and recoverability during the expanding.

In view of more stably obtaining the base film 2 excellent in the expandability and recoverability during the expanding, the density of the olefin-based elastomer may be, but is not particularly limited to, preferably 0.860 g/cm$^3$ or more and less than 0.905 g/cm$^3$, more preferably 0.862 g/cm$^3$ or more and less than 0.900 g/cm$^3$, and particularly preferably 0.864 g/cm$^3$ or more and less than 0.895 g/cm$^3$.

In the olefin-based elastomer, the mass ratio of monomers of olefin-based compounds (also referred to as an "olefin content ratio," in the present description) may preferably be 60 to 100 mass% to the whole monomers used for forming the elastomer. If the olefin content ratio is excessively low, properties as those of elastomer that includes constitutional units originated from olefin will be difficult to appear and the flexibility and rubber-like elasticity may not be readily exhibited. In view of stably obtaining the effects of exhibiting such properties, the olefin content ratio may preferably be 60 mass% or more and more preferably 70 mass% or more.

The content of the thermoplastic elastomer (b3) in the resin composition (R4) may preferably be 10 to 50 mass%, particularly preferably 15 to 45 mass%, and further preferably 20 to 40 mass% . When the content of the thermoplastic elastomer (b3) is 5 mass% or more, more excellent expanding properties can be ensured. When the content of the thermoplastic elastomer (b3) is 40 mass% or less, the content of the polyethylene-based resin (b2) can be ensured to more effectively suppress the blocking when winding up the film.

The resin composition (R4) can be obtained by melting and mixing the polyethylene-based resin (b2) and the thermoplastic elastomer (b3). The method of melting and mixing is the same as the previously-described method.

The resin composition (R4) may contain other polymers and/or various additives as in the resin composition (R3) in addition to the above two components (b2) and (b3).

(2-3) Thickness of Second Resin Layer (B)

The thickness of the second resin layer (B) may preferably be 30 to 120 μm and particularly preferably 40 to 100 μm. When the thickness of the second resin layer (B) is within the above range, excellent expanding properties of the base film 2 can readily be maintained at high level.

In the present embodiment, the second resin layer (B) is composed of one resin layer, but the second resin layer (B) may also have a structure comprising a plurality of resin layers. In this case, each layer that constitutes the second resin layer (B) may have the previously-described physical properties and compositional features of the second resin layer (B).

(3) Other Physical Properties of Base Film

The fracture elongation of the base film 2 may preferably be 100% or more and particularly preferably 200% or more. The base film 2 having a fracture elongation of 100% or more is less likely to fracture during the expanding step and chips formed by cutting a cut object can be readily separated from one another.

The thickness of the base film 2 is not particularly limited, but may preferably be 50 to 400 μm in general, more preferably 50 to 300 μm, and particularly preferably 60 to 200 μm.

(4) Method of Manufacturing Base Film

The base film 2 may be manufactured by coextrusion molding in which film formation and lamination of the first resin layer (A) and second resin layer (B) are concurrently performed, or may also be manufactured by separately performing film formation of the first resin layer (A) and second resin layer (B) and thereafter laminating the first resin layer (A) and second resin layer (B) using an adhesive or the like. It may be preferred to manufacture the base film 2 by coextrusion molding in consideration of the simplicity of the manufacturing method and the interfacial adhesion between the first resin layer (A) and the second resin layer (B).

2. Pressure Sensitive Adhesive Layer

In the dicing sheet 1 according to the present embodiment, the pressure sensitive adhesive layer 3 is laminated so as to be in contact with the first resin layer (A) of the base film 2.

Examples of the pressure sensitive adhesive that constitutes the pressure sensitive adhesive layer 3 include, but are not particularly limited to, those which are usually used for the dicing sheet 1, such as rubber-based, acrylic-based, epoxy-based, silicone-based and polyvinyl ether-based pressure sensitive adhesives, and energy ray curable-type (including ultraviolet curable-type) and heat curable-type pressure sensitive adhesives may also be used. When the dicing sheet 1 according to the present embodiment is used as a dicing/die-bonding sheet, appropriate adhesives may be used, such as pressure sensitive adhesive, thermoplastic adhesive and B-stage adhesive, which have both the wafer fixation function and die adhesion function.

The thickness of the pressure sensitive adhesive layer 3 is not particularly limited and may ordinarily be 3 to

100 μm and preferably 5 to 80 μm.

3. Other Constitutional Elements of Dicing Sheet

The dicing sheet 1 may further comprise other constitutional elements in addition to the base film 2 and the pressure sensitive adhesive layer 3. Examples of such other constitutional elements include a release sheet for protecting the surface of the pressure sensitive adhesive layer 3 which is not in contact with the first resin layer (A), that is, the surface to be attached to a cut object.

Examples of the release sheet to be used include, for example, a polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene-vinyl acetate film, ionomer resin film, ethylene/(meth)acrylic acid copolymer film, ethylene/ (meth) acrylic ester copolymer film, polystyrene film, polycarbonate film, polyimide film, and fluorine resin film. Crosslinked films thereof may also be used. The release sheet may be a laminate film obtained by laminating a plurality of such films.

It may be preferred that the release surface (surface at the side facing the pressure sensitive adhesive layer 3; surface having releasability from the pressure sensitive adhesive layer 3) of the above release sheet is subjected to release treatment. Examples of a release agent to be used for the release treatment include, for example, alkyd-based, silicone-based, fluorine-based, unsaturated polyester-based, polyolefin-based and wax-based release agents.

The thickness of the release sheet is not particularly limited and may ordinarily be about 20 to 150 μm.

4. Method of Manufacturing Dicing Sheet

The dicing sheet 1 according to the present embodiment can be manufactured by an ordinary method. For example, the dicing sheet 1 can be manufactured through preparing a coating agent that contains a material to constitute the pressure sensitive adhesive layer 3 and if necessary further contains some solvent, coating an exposed surface of the first resin layer (A) of the base film 2 with the coating agent using a coater such as roll coater, knife coater, knife-over-roll coater, air knife coater, die coater, bar coater, gravure coater and curtain coater, and drying the coating agent to form the pressure sensitive adhesive layer 3. In an alternative embodiment, the dicing sheet 1 can be manufactured through coating the release surface of a desired release sheet with the above coating agent, drying the coating agent to form the pressure sensitive adhesive layer 3, and attaching the side of the first resin layer (A) of the base film 2 to the pressure sensitive adhesive layer 3 by applying pressure.

5. Use Application of Dicing sheet

The dicing sheet 1 according to the present embodiment can preferably be used as a dicing sheet that is used in the dicing step and expanding step for semiconductor wafers, BGA-type packages, etc.

The embodiments heretofore explained are described to facilitate understanding of the present invention and are not described to limit the present invention. Therefore, it is intended that the elements disclosed in the above embodiments include all design changes and equivalents to fall within the technical scope of the present invention.

For example, as in a base film 20 of the dicing sheet 10 illustrated in FIG. 2, one or more other layers, for example, a third resin layer (C), may be laminated between the first resin layer (A) and the second resin layer (B).

In this case, it may be preferred that the tensile elastic modulus of the third resin layer (C) is not higher than the tensile elastic modulus of the first resin layer (A). This ensures excellent expanding properties of the base film 2.

Material of the third resin layer (C) may preferably contain an olefin-based resin as in the first resin layer (A) and second resin layer (B) and may particularly preferably contain a polymer of which the constitutional monomer is ethylene. This can enhance the interfacial adhesion between the third resin layer (C) and the first resin layer (A) and second resin layer (B).

The thickness of the third resin layer (C) is not particularly limited, provided that the previously-described effects of the first resin layer (A) and second resin layer (B) are not impaired, but may preferably be 15% or less, particularly preferably 10% or less, and further preferably 5% or less, as a layer thickness ratio to the whole of the base film 20. The lower limit of the layer thickness ratio may ordinarily be 1% or more, which may be a thickness that allows the third resin layer (C) to exert its functionality.

[Examples]

Hereinafter, the present invention will be more specifically described with reference to examples, etc., but the scope of the present invention is not limited to these examples, etc.

«Examples 1 to 8 and Comparative Examples 1 to 6»

1. Production of Base Film

(1) Preparation of Raw Material for Extrusion of First Resin Layer (A)

Raw material for extrusion of each first resin layer (A) was obtained by mixing the raw materials below at compounding ratios (mass ratios) as listed in Table 1 and melting and kneading them using a biaxial kneading machine (Labo-Plastomill available from Toyo Seiki Seisaku-sho, LTD).

<Raw Materials for First Resin Layer (A)>

- Ethylene-based copolymer (a1)-1: ethylene/methacrylic acid copolymer (ratio of constitutional units originated from ethylene: 91 mass%, ratio of constitutional units originated from methacrylic acid: 9 mass%, MFR at 190 °C and 2.16 kgf: 3.0 g/10 min)
- Ethylene-based copolymer (a1)-2: ethylene/methacrylic acid copolymer (ratio of constitutional units originated from ethylene: 85 mass%, ratio of constitutional units originated from methacrylic acid: 15 mass%, MFR at 190 °C and 2.16 kgf: 60 g/10 min)
- Ternary copolymer (a2): ethylene/glycidyl methacrylate/n-butyl acrylate copolymer (ratio of constitutional units originated from ethylene: 67 mass%, ratio of constitutional units originated from glycidyl methacrylate: 5 mass%, ratio of constitutional units originated from n-butyl acrylate: 28 mass%, MFR at 190°C and 2.16 kgf: 12 g/10 min)
- Polyolefin (a3)-1: homopolypropylene (Prime Polypro (registered trademark) F-113G available from Prime Polymer Co. , Ltd., density: 0.91 g/cm$^3$, MFR at 230°C and 2.16 kgf: 3.0 g/10 min)
- Polyolefin (a3)-2: random polypropylene (Prime Polypro (registered trademark) F-219DA available from Prime Polymer Co., Ltd., density: 0.91 g/cm$^3$, MFR at 230°C and 2.16 kgf: 8.0 g/10 min)
- Ethylene/(meth)acrylic acid copolymer (a4): ethylene/methacrylic acid copolymer (Nucrel (registered trademark) N0903HC available from DUPONT-MITSUI POLYCHEMICALS CO., LTD., ratio of constitutional units originated from methacrylic acid: 9 mass%, tensile elastic modulus at 23°C: 140 MPa)
- Polypropylene-based resin (a5) : ethylene/polypropylene random copolymer (Prime Polypro (registered trademark) F-227D available from Prime Polymer Co., Ltd., tensile elastic modulus at 23°C: 950 MPa, MFR at 230°C and 2.16 kgf: 7.0 g/10 min, melting peak temperature: 135°C, melting heat quantity: 81.9 J/g)
- Norbornene-based resin: cycloolefin copolymer (TOPAS 7010 available from POLYPLASTICS CO., LTD., resin density at 23°C: 1.02 g/cm$^3$, tensile elastic modulus at 23°C: 2,100 MPa, liquefaction temperature: 142°C)

(2) Preparation of Raw Material for Extrusion of Second Resin Layer (B)

Raw material for extrusion of each second resin layer (B) was obtained by melting and kneading the raw materials below at compounding ratios (mass ratios) as listed in Table 1 using a biaxial kneading machine (Labo-Plastomill available from Toyo Seiki Seisaku-sho, LTD).

<Raw Materials for Second Resin Layer (B)>

- Ethylene-based copolymer (b1)-1: ethylene/methacrylic acid copolymer (Nucrel (registered trademark) N0903HC available from DUPONT-MITSUI POLYCHEMICALS CO., LTD., ratio of constitutional units originated from methacrylic acid: 9 mass%, tensile elastic modulus at 23°C: 140 MPa)
- Ethylene-based copolymer (b1)-2: ethylene/methacrylic acid copolymer (Nucrel (registered trademark) N1207C available from DUPONT-MITSUI POLYCHEMICALS CO., LTD., ratio of constitutional units originated from methacrylic acid: 12 mass%, tensile elastic modulus at 23°C: 170 MPa)
- Ethylene-based copolymer (b1)-3: ethylene/methacrylic acid copolymer (Nucrel (registered trademark) AN4214HC available from DUPONT-MITSUI POLYCHEMICALS CO., LTD., ratio of constitutional units originated from methacrylic acid: 4 mass%, tensile elastic modulus at 23°C: 160 MPa)
- Ethylene-based copolymer (b1)-4: linear low-density polyethylene (Umerit (registered trademark) 2540F available from Ube-Maruzen Polyethylene Co., Ltd., ratio of constitutional units originated from methacrylic acid: 0 mass%, resin density at 23°C: 0.923 g/cm$^3$, tensile elastic modulus at 23°C: 210 MPa)

- Polyethylene-based resin (b2): linear low-density polyethylene (Evolue SP2040 available from Prime Polymer Co., Ltd., resin density: 0.918 g/cm$^3$, melting heat quantity ΔH: 124.1 J/g, tensile elastic modulus at 23°C: 160 MPa, MFR at 190°C and 2.16 kgf: 3.8 g/10 min)
- Thermoplastic elastomer (b3): olefin-based elastomer (TPO) (Tafmer DF640 available from Mitsui Chemicals, Inc., resin density: 0.864 g/cm$^3$, melting heat quantity ΔH: 33.43 J/g, tensile elastic modulus at 23°C: 4.5 MPa)

(3) Extrusion Molding of Resin Layers (Molding of Base Film)

The raw material for extrusion of each first resin layer (A) and the raw material for extrusion of each second resin layer (B) were subjected to coextrusion molding using a compact T-die extruder (Labo-plastomill available from Toyo Seiki Seisaku-sho, LTD.) and a base film of two-layer structure was obtained, comprising the first resin layer (A) and the second resin layer (B) having thicknesses (μm) as listed in Table 1. In Comparative Example 3, however, extrusion molding was performed using the above compact T-die extruder to obtain a base film of single layer having a thickness of 100 μm.

2. Preparation of Pressure Sensitive Adhesive

An energy ray curable-type pressure sensitive adhesive composition was obtained by mixing 100 mass parts of a copolymer (Mw: 500,000) provided by copolymerization of 95 mass parts of n-butyl acrylate and 5 mass parts of acrylic acid, 120 mass parts of urethane acrylate oligomer (Mw: 8,000), 5 mass parts of isocyanate-based curing agent (Coronate L available from NIPPON POLYURETHANE INDUSTRY CO., LTD.), and 4 mass parts of photopolymerization initiator (IRGACURE 184 available from Ciba Specialty Chemicals Inc).

3. Formation of Pressure Sensitive Adhesive Layer (Production of Dicing Sheet)

The obtained energy ray curable-type pressure sensitive adhesive composition was applied to the release treatment surface of a release sheet treated with silicone treatment (SP-PET38111(S) available from LINTEC Corporation) to have a film thickness after drying of 10 μm and dried at 100°C for 1 minute to form a pressure sensitive adhesive layer, which was then attached to one surface of the above base film (surface at the side of the first resin layer (A)) thereby to transfer the pressure sensitive adhesive layer to the base film, and a dicing sheet was thus obtained.

«Exemplary Test 1» <Measurement of Crystallinity>

The raw material for extrusion of the second resin layer (B) prepared in each of the examples and comparative examples was subjected to extrusion molding using a compact T-die extruder (Labo-plastomill available from Toyo Seiki Seisaku-sho, LTD.) and a resin film of single layer was obtained as a sample for measurement, comprising the second resin layer (B) having a thickness of 100 μm.

The above sample for measurement was heated at a heating rate of 20°C/min from the ordinary temperature to 250°C and held at 250°C for 10 minutes. Then, the sample was cooled at a cooling rate of 20°C/min to -60°C, held at -60°C for 10 minutes, and thereafter heated again at a heating rate of 20°C/min to 250°C to obtain a DSC curve with an endothermic peak area, from which the melting heat quantity (W/g) was obtained. The endothermic peak area was measured using a differential scanning calorimeter (DSC: available from TA Instruments). Then, from a value of the obtained melting heat quantity (W/g), the crystallinity was obtained using the equation below. Results are listed in Table 1.

```
Crystallinity (%)=(melting heat quantity/293)×100
```

«Exemplary Test 2» <Measurement of Tensile Elastic Modulus>

The raw materials for extrusion of the first resin layer (A) and second resin layer (B) prepared in each of the examples and comparative examples were subjected respectively to extrusion molding using a compact T-die extruder (Labo-plastomill available from Toyo Seiki Seisaku-sho, LTD.) and single-layer resin films having a thickness of 100 μm were produced.

The single-layer resin films of the first resin layer (A) and second resin layer (B) obtained in the above and the base films produced in the examples and comparative examples were each cut into a test specimen of 15 mm (MD direction)×140 mm (CD direction) and the tensile elastic modulus at 23°C was measured in accordance with JIS K7161 : 1994 and JIS K7127: 1999. Specifically, tensile test was performed for the above test specimen with a rate of 200 mm/min using a tensile tester (Autograph AG-IS 500N available from SHIMADZU CORPORATION) after setting the distance between chucks at 100 mm, thereby to measure the tensile elastic modulus (MPa). The obtained measurement results were also used as the basis to calculate the ratio of a tensile elastic modulus of the first resin layer (A) to a tensile elastic modulus of the second resin layer (B) ((A)/(B)). Results are listed in Table 1.

«Exemplary Test 3» <Evaluation of Dicing Debris>

After attaching the pressure sensitive adhesive layer of the dicing sheet produced in each of the examples and comparative examples to a mirror wafer, they were set up on a dicing apparatus (DFD-6361 available from DISCO Corporation) and dicing was performed under the condition below:

- workpiece (adherend): mirror wafer;
- workpiece size: 6 inches diameter, 100 $\mu$m thickness;
- dicing blade: 27HECC available from DISCO Corporation;
- blade rotating speed: 30,000 rpm;
- dicing speed: 10 mm/sec;
- cutting depth: cutting into the base film with a depth of 20 $\mu$m from the interface with the pressure sensitive adhesive layer; and
- dicing size: 10 mm×10 mm.

After performing the above dicing, the cut chips were removed by irradiating the base film side with ultraviolet rays (160 mJ/cm$^2$). Among lengthwise and breadthwise dicing lines, one lengthwise line and one breadthwise line located near the respective centers were subjected to a test in which the number of filament-like debris particles of a length of 100 $\mu$m or more generated on each line was counted using a digital microscope (VHX-100 available from KEYENCE CORPORATION, magnification: ×100). The counted number of filament-like debris particles was evaluated in accordance with the criteria below:

A: the number of filament-like debris particles was 0 to 10;
B: the number of filament-like debris particles was 11 to 15; and
C: the number of filament-like debris particles was 16 or more.

Those falling under A and B were determined good (○: the generation of dicing debris was suppressed) and those falling under C were determined bad (×: the generation of dicing debris was not suppressed). Results are listed in Table 1.

«Exemplary Test 4» <Evaluation of Expanding Properties (Expandability) >

After performing the dicing under the above dicing condition in Exemplary Test 3, an expanding jig (Die Bonder CSP-100VX available from NEC Machinery Corporation) was used to pull down the dicing sheet by 10 mm at a speed of 300 mm/min (Condition 1) and by 20 mm at a speed of 300 mm/min (Condition 2). The presence or absence of fracture of the dicing sheet was confirmed under the respective conditions and evaluated in accordance with the criteria below:

A: fracture was not confirmed under both Conditions 1 and 2;
B: expansion was possible under Condition 1, but fracture was confirmed under Condition 2; and
C: fracture was confirmed under each of Conditions 1 and 2.

Those falling under A and B were determined good (○: excellent expandability of the expanding properties) and those falling under C were determined bad (×: poor expandability of the expanding properties). Results are listed in Table 1.

«Exemplary Test 5» <Evaluation of Expanding Properties (Recoverability)>

After performing the dicing under the above dicing condition in Exemplary Test 3, an expanding jig (Die Bonder CSP-100VX available from NEC Machinery Corporation) was used to pull down the dicing sheet by 10 mm at a speed of 300 mm/min and the dicing sheet was then held for 1 minute in this state. Thereafter, the sample was heated in an oven of 80°C for 1 minute and the slack amount of the dicing sheet (maximum distance when the lower surface of the dicing sheet moved downward in the vertical direction) was measured and evaluated in accordance with the criteria below:

A: slack amount of the sample was less than 1.5 mm;
B: slack amount of the sample was 1.5 mm or more and less than 3 mm; and
C: slack amount of the sample was 3 mm or more.

Those falling under A and B were determined good (○: excellent recoverability of the expanding properties) and those falling under C were determined bad (×: poor recoverability of the expanding properties). Results are listed in Table 1.

«Exemplary Test 6» <Evaluation of Blocking Resistance>

The base film (thickness of 100 $\mu$m and width of 300 mm) produced in each of the examples and comparative examples was wound up around a 3-inch core and used as a sample for test. This sample for test was stored in a dry oven set at a temperature of 70°C for 24 hours and the film was then wound off using a winding-off machine. The situation at that time was evaluated in accordance with the criteria below:

A: the film was able to be wound off without blocking;
B: blocking occurred in a part or in whole, but the film was able to be wound off; and
C: blocking occurred completely across the film and the film was not able to be wound off.

Those falling under A and B were determined good (○: excellent blocking resistance) and those falling under C were determined bad (×: poor blocking resistance). Results are listed in Table 1.

[Table 1]

| | | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|---|---|---|
| First resin layer (A) — R1 | Ethylene-based copolymer (a1)-1: Ethylene/methacrylic acid copolymer | – | – | – | – | – | 78.5 | – | 78.5 | – | – | – | – | – | – |
| | Ethylene-based copolymer (a1)-2: Ethylene/methacrylic acid copolymer | – | – | – | – | – | – | 80 | – | – | – | – | – | – | – |
| | Ternary copolymer (a2): Ethylene/glycidyl methacrylate/n-butyl acrylate copolymer | – | – | – | – | – | 1.5 | 5 | 1.5 | – | – | – | – | – | – |
| | Polyolefin (a3)-1: Homopolypropylene (Prime Polypro F-113G) | – | – | – | – | – | 20 | – | 20 | – | – | – | – | – | – |
| | Polyolefin (a3)-2: Random polypropylene (Prime Polypro F-219DA) | – | – | – | – | – | – | 15 | – | – | – | – | – | – | – |
| First resin layer (A) — R2 | Ethylene/(meth)acrylic acid copolymer (a4): Ethylene/methacrylic acid copolymer (Nucrel N0903HC, MAA9%) | 75 | 85 | 95 | 80 | 80 | – | – | – | 85 | 85 | 85 | 85 | 85 | 80 |
| | Polypropylene-based resin (a5): Random polypropylene (Prime Polypro F-227D) | 25 | 15 | 5 | 20 | 20 | – | – | – | 15 | 15 | 15 | 15 | 15 | – |
| | Norbornene-based resin: Cycloolefin copolymer (TOPAS 7010) | – | – | – | – | – | – | – | – | – | – | – | – | – | 20 |
| Second resin layer (B) — R3 | Ethylene-based copolymer (b1)-1: Ethylene/methacrylic acid copolymer (Nucrel N0903HC, MAA9%) | 100 | 100 | 100 | – | – | 100 | 100 | – | – | – | – | 100 | 100 | 100 |
| | Ethylene-based copolymer (b1)-2: Ethylene/methacrylic acid copolymer (Nucrel N1207C, MAA12%) | – | – | – | 100 | – | – | – | – | – | – | – | – | – | – |
| | Ethylene-based copolymer (b1)-3: Ethylene/methacrylic acid copolymer (Nucrel AN4214HC, MAA4%) | – | – | – | – | 100 | – | – | – | – | – | – | – | – | – |
| | Ethylene-based copolymer (b1)-4: Linear low-density polyethylene (Umerit 2540F, MAA0%) | – | – | – | – | – | – | – | – | 100 | – | – | – | – | – |
| Second resin layer (B) — R4 | Polyethylene-based resin (b2): Linear low-density polyethylene (Evolue SP2040) | – | – | – | – | – | – | – | 70 | – | 50 | – | – | – | – |
| | Thermoplastic elastomer (b3): Olefin-based elastomer (Tafmer DF640) | – | – | – | – | – | – | – | 30 | – | 50 | – | – | – | – |
| Layer structure | Number of layer(s) | 2 | 2 | 2 | 2 | 2 | 2 | 2 | 2 | 2 | 2 | 1 | 2 | 2 | 2 |
| | Thickness of first resin layer (A) [µm] | 40 | 40 | 40 | 40 | 40 | 40 | 40 | 40 | 40 | 40 | 100 | 10 | 70 | 40 |
| | Thickness of second resin layer (B) [µm] | 60 | 60 | 60 | 60 | 60 | 60 | 60 | 60 | 60 | 60 | – | 90 | 30 | 60 |
| | Ratio of thickness of (A) [%] | 40 | 40 | 40 | 40 | 40 | 40 | 40 | 40 | 40 | 40 | 100 | 10 | 70 | 40 |
| Crystallinity of second resin layer (B) [%] | | 33.8 | 33.8 | 33.8 | 30.1 | 38.8 | 33.8 | 33.8 | 34.7 | 47.8 | 27.0 | – | 33.8 | 33.8 | 33.8 |
| Tensile elastic modulus | First resin layer (A) [MPa] | 350 | 260 | 175 | 300 | 300 | 200 | 180 | 200 | 260 | 260 | 260 | 260 | 260 | 480 |
| | Second resin layer (B) [MPa] | 140 | 140 | 140 | 170 | 160 | 140 | 140 | 160 | 210 | 220 | – | 140 | 140 | 140 |
| | Ratio ((A)/(B)) | 2.50 | 1.86 | 1.25 | 1.76 | 1.88 | 1.40 | 1.30 | 1.25 | 1.43 | 1.36 | 1.00 | 2.14 | 2.14 | 3.4 |
| | Base film [MPa] | 220 | 190 | 150 | 220 | 210 | 160 | 150 | 180 | 240 | 240 | 260 | 150 | 220 | 280 |
| Evaluation of blocking resistance | | O(A) | O(A) | O(A) | O(B) | O(A) | O(A) | O(A) | O(A) | O(A) | ×(C) | O(A) | O(A) | O(A) | O(A) |
| Evaluation of dicing debris | | O(B) | O(A) | O(B) | O(A) | O(A) | O(A) | O(A) | O(A) | O(A) | O(A) | O(A) | ×(C) | O(A) | O(A) |
| Evaluation of expanding properties | Expandability | O(A) | O(A) | O(A) | O(A) | O(A) | O(A) | O(A) | O(A) | O(A) | O(A) | O(B) | O(A) | O(A) | ×(C) |
| | Recoverability | O(A) | O(A) | O(A) | O(A) | O(B) | O(A) | O(A) | O(B) | ×(C) | O(A) | ×(C) | O(A) | ×(C) | ×(C) |

As apparent from Table 1, in the base films produced in the examples, the occurrence of blocking is suppressed. Moreover, in the dicing sheets produced in the examples, the dicing debris is less likely to be generated during the dicing step and the expanding properties during the expanding step are excellent.

[Industrial Applicability]

The base film for dicing sheets and dicing sheet according to the present invention can be preferably used for dicing of semiconductor wafers, various packages, etc.

[Description of Reference Numerals]

1, 10    Dicing sheet
2        Base film (resin layer (A)/resin layer (B))
20       Base film (resin layer (A)/resin layer (C)/resin layer (B))
30       Pressure sensitive adhesive layer

**Claims**

1. A base film for dicing sheets, the base film being used in a dicing sheet comprising the base film and a pressure sensitive adhesive layer laminated on one surface of the base film, wherein
   the base film comprises at least a first resin layer (A) that is in contact with the pressure sensitive adhesive layer of the dicing sheet and a second resin layer (B) that comes into contact with the first resin layer (A) when the base film for dicing sheets is wound up,
   the second resin layer (B) has a crystallinity of 28% to 45%,
   a ratio of a tensile elastic modulus of the first resin layer (A) to a tensile elastic modulus of the second resin layer (B) is 1.2 to 3.0, and
   a ratio of a thickness of the first resin layer (A) to a thickness of the base film for dicing sheets is 20% to 60%.

2. The base film for dicing sheets as recited in claim 1, wherein
   a further layer is laminated between the first resin layer (A) and the second resin layer (B), and
   the further layer has a tensile elastic modulus that is not higher than the tensile elastic modulus of the first resin layer (A).

3. The base film for dicing sheets as recited in claim 1 or 2, wherein at least the first resin layer (A) and the second resin layer (B) contain an olefin-based resin.

4. The base film for dicing sheets as recited in any one of claims 1 to 3, wherein the second resin layer (B) contains at least one selected from a homopolymer of ethylene and a copolymer of ethylene and (meth)acrylic acid and/or (meth)acrylic ester.

5. The base film for dicing sheets as recited in any one of claims 1 to 4, wherein the first resin layer (A) comprises a resin composition (R1) that contains an ethylene-based copolymer (a1) selected from an ethylene/$\alpha,\beta$-unsaturated carboxylic acid copolymer and an ethylene/$\alpha,\beta$-unsaturated carboxylic acid/$\alpha,\beta$-unsaturated carboxylic ester copolymer, a ternary copolymer (a2) having a constitutional unit originated from $\alpha$-olefin, a constitutional unit originated from glycidyl (meth)acrylate or glycidyl unsaturated ether and a constitutional unit originated from vinyl ester or unsaturated carboxylic ester, and a polyolefin (a3).

6. The base film for dicing sheets as recited in claim 5, wherein the ethylene-based copolymer (a1) is an ethylene/(meth)acrylic acid copolymer.

7. The base film for dicing sheets as recited in claim 5 or 6, wherein the ternary copolymer (a2) is an ethylene/glycidyl (meth)acrylate/alkyl acrylate ester copolymer.

8. The base film for dicing sheets as recited in any one of claims 1 to 4, wherein the first resin layer (A) comprises a resin composition (R2) that contains an ethylene/ (meth) acrylic acid copolymer (a4) and a polypropylene-based resin (a5).

9. The base film for dicing sheets as recited in any one of claims 1 to 8, wherein the second resin layer (B) contains an ethylene-based copolymer (b1) that is a copolymer of ethylene and (meth)acrylic acid and/or (meth)acrylic ester.

10. The base film for dicing sheets as recited in claim 9, wherein the ethylene-based copolymer (b1) is an ethylene/(meth)acrylic acid copolymer.

11. The base film for dicing sheets as recited in any one of claims 1 to 8, wherein the second resin layer (B) comprises a resin composition (R4) that contains a polyethylene-based resin (b2) and a thermoplastic elastomer (b3).

12. The base film for dicing sheets as recited in any one of claims 1 to 11, wherein
the first resin layer (A) has a tensile elastic modulus of 140 to 400 MPa, and
the second resin layer (B) has a tensile elastic modulus of 100 to 290 MPa.

13. The base film for dicing sheets as recited in any one of claims 1 to 12, wherein the base film for dicing sheets is formed by coextrusion molding.

14. A dicing sheet comprising a base film and a pressure sensitive adhesive layer laminated on one surface of the base film, wherein
the base film is a base film for dicing sheets as recited in any one of claims 1 to 13, and
the pressure sensitive adhesive layer is laminated so as to be in contact with the first resin layer (A) of the base film for dicing sheets.

Fig. 1

Fig. 2

## INTERNATIONAL SEARCH REPORT

| | International application No. |
|---|---|
| | PCT/JP2014/066146 |

**A. CLASSIFICATION OF SUBJECT MATTER**
*H01L21/301*(2006.01)i, *C09J7/02*(2006.01)i

According to International Patent Classification (IPC) or to both national classification and IPC

**B. FIELDS SEARCHED**

Minimum documentation searched (classification system followed by classification symbols)
H01L21/301, C09J7/02

Documentation searched other than minimum documentation to the extent that such documents are included in the fields searched
Jitsuyo Shinan Koho        1922-1996   Jitsuyo Shinan Toroku Koho   1996-2014
Kokai Jitsuyo Shinan Koho  1971-2014   Toroku Jitsuyo Shinan Koho   1994-2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2014/038353 A1  (Lintec Corp.), 13 March 2014 (13.03.2014), paragraphs [0030], [0080], [0093] (Family: none) | 1-14 |
| A | JP 2007-324456 A  (Nitto Denko Corp.), 13 December 2007 (13.12.2007), paragraphs [0035] to [0047] & US 2007/0281152 A1    & EP 1862494 A1 & KR 10-2007-0115799 A   & CN 101081968 A | 1-14 |
| A | JP 2001-72947 A  (Nitto Denko Corp.), 21 March 2001 (21.03.2001), paragraphs [0006] to [0019] & US 6506490 B1          & EP 1081758 A1 | 1-14 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 13 August, 2014 (13.08.14) | 02 September, 2014 (02.09.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/066146

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-290001 A (Achilles Corp.), 10 December 2009 (10.12.2009), paragraphs [0014] to [0027] (Family: none) | 1-14 |
| A | JP 2004-303999 A (Lonseal Corp.), 28 October 2004 (28.10.2004), paragraphs [0011] to [0034] (Family: none) | 1-14 |
| A | US 2013/0034729 A1 (LINTEC CORP.), 07 February 2013 (07.02.2013), paragraphs [0024] to [0053] & WO 2011/122428 A1 & CN 102834900 A & KR 10-2013-0006470 A | 1-14 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001207140 A
- JP 2010260893 A
- JP 5211234 A